# EUROPÄISCHE PATENTSCHRIFT

(11) **EP 2 255 408 B1**
(45) Veröffentlichungstag und Bekanntmachung des Hinweises auf die Patenterteilung: **04.07.2012**
(21) Anmeldenummer: 09721532.1
(22) Anmeldetag: 13.03.2009
(51) Int. Cl.: H05K 3/32, H01R 4/62

(54) **ELEKTRISCHE VERBINDUNG**
ELECTRICAL CONNECTION
LIAISON ÉLECTRIQUE

(30) Priorität: 20.03.2008 DE 102008015376
(43) Veröffentlichungstag der Anmeldung: 01.12.2010
(73) Patentinhaber: Günther Heisskanaltechnik GmbH, 35066 Frankenberg (DE)
(72) Erfinder: GÜNTHER, Herbert, 35108 Allendorf (DE); SOMMER, Siegrid, 35099 Burgwald (DE); KRETZSCHMAR, Christel, 01809 Dohna (DE); PARTSCH, Uwe, 01309 Dresden (DE)
(74) Vertreter: Buchhold, Jürgen
(86) Internationale Anmeldenummer: PCT/EP2009/001810
(87) Internationale Veröffentlichungsnummer: WO 2009/115234

(56) Entgegenhaltungen:
- GB-A- 1 299 726
- US-A- 3 630 694
- US-B1- 6 410 894

## Beschreibung

Die Erfindung betrifft eine elektrische Verbindung zwischen einem ersten elektrisch leitenden Bauteil aus einem ersten Material und einem zweiten elektrisch leitenden Bauteil aus einem zweiten Material, wobei sich das erste Material von dem zweiten Material unterscheidet.

Derartige elektrische Verbindungen werden beispielsweise eingesetzt, um eine elektrische Verbindung zwischen einer auf einem Substrat angeordneten Heizeinrichtung, insbesondere einer Heizeinrichtung für eine Spritzgießdüse, und einer Anschlussleitung zu erzeugen, die an eine Stromquelle angeschlossen werden kann. Dabei bildet ein elektrisch leitender Heizleiter der Heizeinrichtung oder ein elektrischer Anschluss der Heizeinrichtung das erste elektrisch leitende Bauteil, während die Anschlussleitung das zweite elektrisch leitende Bauteil bildet, oder umgekehrt.

So ist aus dem Stand der Technik US 3 630 694 A bekannt, welche ein Übergangsstück zur Verbindung eines Aluminiumteils mit einem Stahlteil beschreibt. Das Übergangsstück weist hierfür eine Aluminiumschicht und eine Stahlschicht auf, die durch eine ferritische Edelstahlschicht voneinander getrennt sind. Die Stahlschicht wird schließlich mit dem Stahlteil verschweißt und die Aluminiumschicht mit dem Aluminiumteil.

Weiterhin beschäftigt sich GB 1 299 727 A mit dem Verbinden und Trennen von elektrischen mehradrigen Kabeln mit massiven, unrunden Adern. Hierfür wird eine Hülse um die zu verbindenden Enden von zwei Kabeln gelegt, die Innenausnehmungen in Form der Kabel hat. Nach dem Anlegen der Hülse, umfasst diese die gegenüberliegenden Enden der Kabel. Dabei ist sie dicht abgeschlossen und kann anschließend mit Metall aufgefüllt werden. Das Metall verbindet schließlich die Kabel elektrisch leitend.

Bekannt ist außerdem US 6 410 894 B1 (vergl. Oberbegriff des Anspruchs 1), die eine Dickschichtheizun für eine Spritzgießdüse zeigt. An Anschlusspunkten der Dickschichtheizung ist diese mit elektrischen Leitern verbunden. Diese Verbindung ist durch Löten, Epoxid, Schweißen oder Kontaktpaste herstellbar.

Es sind eine Vielzahl von weiteren Anwendungsmöglichkeiten der elektrischen Verbindung gemäß der vorliegenden Erfindung denkbar, wobei nachfolgend der Einfachheit halber nur auf die zuvor genannte Verbindung einer Heizeinrichtung mit einer Anschlussleitung Bezug genommen wird.

Elektrische Verbindungen der zuvor genannten Art werden gewöhnlich erzeugt, indem die Anschlussleitung mithilfe einer Kontaktpaste auf einer Heizleiterbahn einer elektrischen Heizeinrichtung befestigt wird. Die Kontaktpaste ist elektrisch leitend, wodurch die elektrische Verbindung zwischen den elektrisch leitenden Bauteilen erzielt wird.

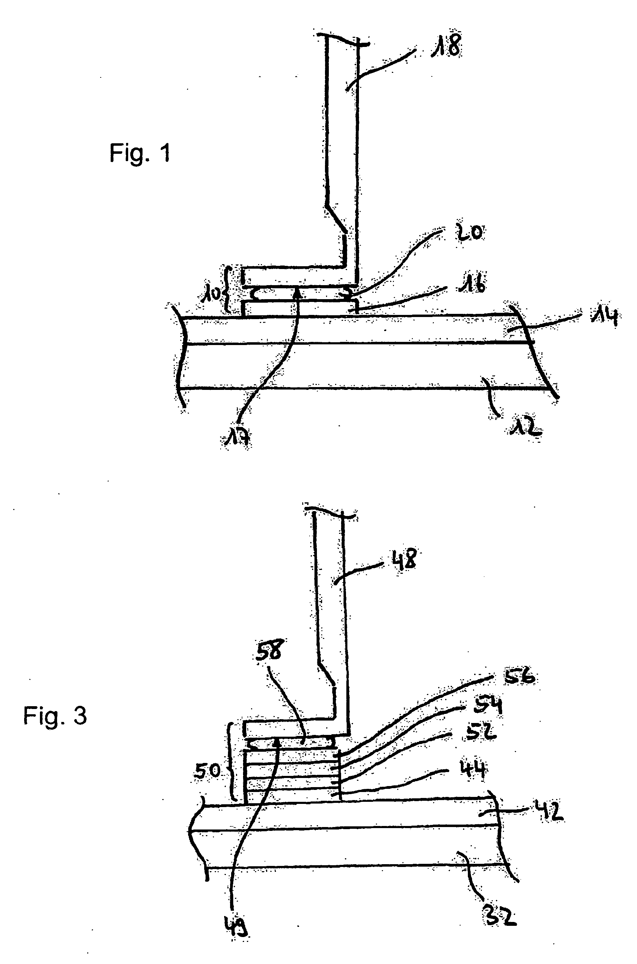

Fig. 1 zeigt eine schematische Ansicht einer bekannten elektrischen Verbindung 10. Die Bezugsziffer 12 bezeichnet ein elektrisch leitendes Substrat, bei dem es sich beispielsweise um das Materialrohr einer Heißkanaldüse handeln kann. Die Bezugsziffer 14 bezeichnet eine Dielektrikumschicht, die als elektrischer Isolator auf dem Substrat 12 aufgetragen ist. Auf der Dielektrikumschicht ist eine Heizleiterbahn 16 aufgebracht, die aus einem ersten elektrisch leitenden Material besteht und Teil einer nicht näher dargestellten elektrischen Heizeinrichtung ist. Die Bezugsziffer 18 bezeichnet eine Anschlussleitung, die unmittelbar oder über eine elektrische Leitung mit einer (nicht dargestellten) Stromquelle verbunden ist. Letztere dient dazu, die Heizleiterbahn 16 der Heizeinrichtung mit elektrischer Energie zu versorgen. Die Anschlussleitung 18 ist ein elektrisch leitender Draht oder eine Litze aus einem zweiten elektrisch leitenden Material, das sich von demjenigen der Heizleiterbahn 16 unterscheidet. Zur Ausbildung der Anschlussfläche 17 ist die Anschlussleitung 18 an ihrem freien Ende umgebogen oder mit einem abgeflachten Fuß versehen, so dass sich in diesem Bereich eine im Wesentlichen L-förmige Form ergibt. Zur Erzeugung der elektrischen Verbindung 10 ist die Anschlussfläche 17 der Anschlussleitung 18 über eine elektrisch leitende Kontaktpaste 20 auf der Heizleiterbahn 16 befestigt, so dass die Anschlussleitung 18 und die Heizleiterbahn 16 elektrisch miteinander verbunden sind.

Die Abscherfestigkeit der in Fig. 1 dargestellten elektrischen Verbindung 10 hängt im Wesentlichen von der Haftung zwischen der Anschlussleitung 18 und der Kontaktpaste 20 einerseits und zwischen der Kontaktpaste 20 und der Heizleiterbahn 16 andererseits ab. Da jedoch das elektrisch leitende erste Material der Heizleiterbahn 16 von dem zweiten elektrisch leitenden Material der Anschlussleitung 18 verschieden ist, muss das Material der Kontaktpaste 20 derart gewählt werden, dass sowohl eine gute Haftfähigkeit in Bezug auf das erste elektrisch leitende Material der Heizleiterbahn 16 als auch eine gute Haftfähigkeit in Bezug auf das zweite elektrisch leitende Material der Anschlussleitung 18 erzielt wird. Beides zugleich ist nicht zu erreichen, so dass die Wahl der Kontaktpaste meist nur eine Kompromisslösung darstellt. Folglich lässt sich mit der zuvor beschrieben Technik keine Verbindung mit optimaler Abscherfestigkeit erzielen. Je nach Art der Kontaktpaste können sich bei höheren Temperaturen zudem Haftprobleme ergeben, was insbesondere bei Heißkanaldüsen von Nachteil ist, insbesondere dann, wenn sich die Kontakte ganz oder teilweise lösen.

Ziel der Erfindung ist es, diese und weitere Nachteile des Standes der Technik zu vermeiden und eine alternative elektrische Verbindung zwischen einem ersten elektrisch leitenden Bauteil aus einem ersten Material und einem zweiten elektrisch leitenden Bauteil aus einem zweiten Material zu schaffen, die optimale Hafteigenschaften aufweist. Insbesondere soll die Abscherfestigkeit zwischen den leitenden Bauteilen deutlich verbessert werden, so dass diese auch bei stärkeren mechanischen Belastungen fest miteinander verbunden sind. Angestrebt wird ferner eine temperaturstabile Verbindung, die einen dauerhaft zuverlässigen elektrischen Kontakt zwischen den Bauteilen gewährleistet.

Hauptmerkmale der Erfindung sind im kennzeichnenden Teil von Anspruch 1 angegeben. Ausgestaltungen sind Gegenstand der Ansprüche 2 bis 15.

Bei einer elektrischen Verbindung zwischen einem ersten elektrisch leitenden Bauteil aus einem ersten Material und einem zweiten elektrisch leitenden Bauteil aus einem zweiten Material, wobei das erste Material und das zweite Material unterschiedlich sind, und wobei das erste elektrisch leitende Bauteil eine Heizeinrichtung einer Spritzgießdüse ist, sieht die Erfindung vor, dass zwischen den elektrisch leitenden Bauteilen wenigstens zwei die Verbindung erzeugende, elektrisch leitende Haftschichten angeordnet sind, wobei die Haftschichten unterschiedliche Eigenschaften, unterschiedliche Zusammensetzungen und/oder unterschiedliche Haftschichtmaterialien aufweisen, und wobei sich die Haftschichtmaterialien von dem ersten und dem zweiten Material unterscheiden.

Durch diese Anordnung ist es möglich, eine optimale Verbindung zwischen dem ersten Bauteil und dem zweiten Bauteil zu schaffen, obwohl diese aus unterschiedlichen Materialien bestehen, denn die zwischen den Bauteilen vorgesehen Haftschichten können bezüglich ihrer Eigenschaften, Zusammensetzungen und/oder Haftschichtmaterialien stufen- bzw. schichtweise an die jeweils unterschiedlichen Materialien der zu verbindenden Bauteile angepasst werden. Der Übergang von dem ersten elektrisch leitenden Bauteil aus dem ersten Material und dem zweiten elektrisch leitenden Bauteil aus dem zweiten Material erfolgt mithin relativ sanft, indem beispielsweise die erste Haftschicht an das erste Material des ersten Bauteils und die zweite Haftschicht an das Material der ersten Haftschicht sowie an das zweite Material des zweiten Bauteils angepasst wird. Auf diese Weise erreicht man zwischen den einzelnen Schichten eine jeweils optimale Haftfestigkeit und damit eine stets optimale Abscherfestigkeit zwischen den Bauteilen. Dementsprechend sieht die Erfindung weiter vor, dass jede Haftschicht an eine jeweils direkt benachbart angeordnete Haftschicht und/oder an ein direkt benachbart angeordnetes elektrisch leitendes Bauteil angepasst ist, wobei bevorzugt jede Haftschicht derart gewählt oder ausgebildet ist, dass deren Eigenschaften, Zusammensetzung und/oder Haftschichtmaterial an die Eigenschaften, die Zusammensetzung und/oder das Haftschichtmaterial einer jeweils direkt benachbart angeordneten Haftschicht und/oder an die Eigenschaften, die Zusammensetzung und/oder das Material eines direkt benachbart angeordneten elektrisch leitenden Bauteils angepasst ist.

Mithin ist nicht mehr nur eine Kontaktschicht vorhanden, die zwei Bauteile aus unterschiedlichen Materialien elektrisch direkt miteinander verbinden muss. Die Verbindung erfolgt vielmehr in mehreren Stufen mit einer Schichtfolge, wobei jede Schicht eine optimierte, temperaturstabile Verbindung schafft, so dass die Bauteile dauerhaft fest miteinander verbunden sind und selbst stärkeren mechanischen Belastungen oder den im Spritzgießverfahren auftretenden thermischen Zyklen, insbesondere auch bei höheren Temperaturen, problemlos stand halten.

Dazu trägt insbesondere bei, wenn die Eigenschaften, die Zusammensetzung und/oder das Haftschichtmaterial einer jeden Haftschicht derart gewählt ist, dass deren Haftfähigkeit an die Haftfähigkeit einer jeweils direkt benachbart angeordneten Haftschicht und/oder an die Haftfähigkeit eines direkt benachbart angeordneten elektrisch leitenden Bauteils angepasst ist. Zweckmäßig hat dabei jede Haftschicht eine andere Haftfähigkeit.

Sämtliche Schichten werden damit bezüglich ihrer Hafteigenschaften schrittweise aufeinander abgestimmt bzw. aneinander angepasst, wodurch insgesamt eine äußerst feste und dauerhaft stabile Verbindung entsteht mit einer gegenüber herkömmlichen elektrischen Verbindungen der eingangs beschriebenen Art erhöhten Abscherfestigkeit.

Eine andere Eigenschaft, die zwischen den einzelnen Haftschichten und den Bauteilen aufeinander abgestimmt werden kann, ist die thermische Ausdehnung. Die aus unterschiedlichen Materialien gefertigen, elektrisch zu verbindenden Bauteile weisen oft Wärmeausdehnungskoeffizienten auf, die relativ weit auseinander liegen, so daß bei höheren Temperaturen Spannungen innerhalb der Verbindung auftreten können. Dies kann zur Rißbildung oder gar zum Ablösen der Bauteile führen. Mit Hilfe der einzelnen Haftschichten lassen sich die Wärmedehnungseigenschaften der zu verbindenden Bauteile schrittweise annähern, so daß beispielsweise beim Betrieb einer Heizvorrichtung innerhalb der Verbindung keine Spannungen mehr auftreten können.

Auf vorteilhafte Weise bilden die Haftschichten bezüglich ihrer Eigenschaften, ihrer Zusammensetzungen, ihrer Haftschichtmaterialien, ihrer Haftfähigkeiten und/oder ihrer Wärmeausdehnungseigenschaften mithin einen Gradientenaufbau, der nicht nur eine optimale elektrische Verbindung schafft, sondern zudem mechanisch und thermisch äußerst stabil ist.

Eine Weiterbildung der Erfindung sieht vor, dass das Haftschichtmaterial jeder Haftschicht ein Lötmaterial, eine Kontaktpaste oder eine Dickschichtpaste ist, wobei das Haftschichtmaterial jeder Haftschicht beispielsweise Silber, Palladium und/oder wenigstens einen Glasphasenanteil umfasst. Diese Materialien lassen sich gut miteinander kombinieren, so dass die gewünschten Eigenschaften bzw. Zusammensetzungen der Schichten erreicht werden können. Auch die Verarbeitung ist einfach zu realisieren, so lassen sich z.B. das Lötmaterial, die Kontaktpaste oder die Dickschichtpaste als Schichten im Siebdruckverfahren aufbringen. Der gesamte Schichtaufbau nimmt nur wenig Raum ein, so dass die Verbindung insgesamt relativ niedrig ist, was gerade bei Heißkanaldüsen von Vorteil ist.

Gemäß einem weiteren Aspekt der vorliegenden Erfindung ist eines der elektrisch leitenden. Bauteile eine elektrische Heizeinrichtung einer Spritzgießdüse, wobei als Heizeinrichtung bevorzugt eine so genannte Dickschichtheizung eingesetzt wird. In diesem Fall wäre das elektrisch leitende Bauteil das Ende einer Heizleiterbahn, die auf dem Materialrohr der Spritzgießdüse aufgebracht ist.

Das andere elektrisch leitende Bauteil kann ein Draht oder eine Litze sein, oder man verwendet einen elektrisch leitenden Anschlussstift, der einen stiftförmigen Abschnitt und einen Verbindungsabschnitt aufweist. Der stiftförmige Abschnitt wird über eine weiterführende elektrische Leitung mit einer Energiequelle verbunden, während der Verbindungsabschnitt zur Anbindung des Anschlussstifts an eine der Haftschichten dient.

Gemäß einem weiteren Aspekt der Erfindung ist der Verbindungsabschnitt vorteilhaft scheibenförmig ausgebildet. Er weist insbesondere einen größeren Durchmesser als der stiftförmige Abschnitt auf, um die auf den Anschlussstift wirkenden Zugbelastungen in allen Richtungen gleichmäßig zu verteilen. Auf diese Weise kann die Abschergefahr weiter verringert werden. Die Haftung wird insgesamt weiter erhöht.

In vorteilhafter Weiterbildung weist die der Haftschicht zugewandte Seite des Verbindungsabschnitts bevorzugt eine Kontur auf, die an die Kontur des anderen elektrisch leitenden Bauteils angepasst ist. Durch eine derartige Konturanpassung wird die Festigkeit der Verbindung und entsprechend die Abscherfestigkeit noch weiter verbessert.

Schließlich ist zwischen dem stiftartigen Abschnitt und dem Verbindungsabschnitt bevorzugt zumindest ein Übergangsabschnitt vorgesehen, der derart ausgebildet ist, dass der Durchmesser des stiftförmigen Abschnitts und derjenige des Verbindungsabschnittes stufenartig oder kontinuierlich ineinander übergehen. Durch einen derartigen Übergang wird die Festigkeit zwischen den beiden Abschnitten verbessert, so dass entsprechend die Lebensdauer des Anschlussstiftes erhöht werden kann.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine schematische Ansicht einer bekannten elektrischen Verbindung,
- Fig. 2: eine schematische Ansicht einer Spritzgießdüse,
- Fig. 3: eine schematische Ansicht einer elektrischen Verbindung gemäß einer ersten Ausführungsform der vorliegenden Erfindung, die für die in Fig. 2 dargestellte Spritzgießdüse verwendet werden kann,
- Fig. 4: eine schematische Ansicht einer elektrischen Verbindung gemäß einer zweiten Ausführungsform der vorliegenden Erfindung, die für die in Fig. 2 dargestellte Spritzgießdüse verwendet werden kann, und
- Fig. 5: eine schematische Ansicht einer alternativen Ausgestaltung eines Anschlussstiftes, der für die in Fig. 4 dargestellte Anordnung verwendet werden kann.

Gleiche Bezugsziffern beziehen sich nachfolgend auf gleiche oder gleichartige Bauteile.

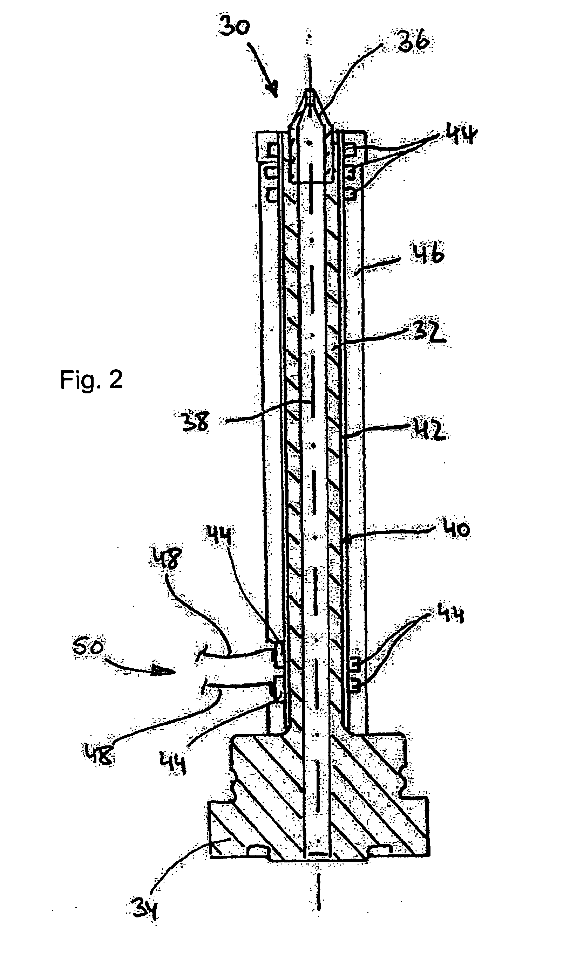

Die in den Fig. 2 bis 6 allgemein mit 50 bzw. 60 bezeichnete Verbindung dient der elektrischen Anbindung einer (nicht näher bezeichneten) elektrischen Heizeinrichtung einer Heißkanaldüse 30 an eine Stromversorgung, insbesondere an ein (nicht gezeigtes) Temperatur-Regelgerät. Die Heißkanaldüse 30 ist Bestandteil einer (nicht näher dargestellten) Spritzgießvorrichtung für die thermoplastische Kunststoffverarbeitung. Sie hat ein insgesamt zylindrisches Materialrohr 32, das mit einem endseitig ausgebildeten Sockel 34 an einem (ebenfalls nicht dargestellten) Verteiler befestigt ist. In das sich in Axialrichtung längs erstreckende Materialrohr 32 ist endseitig eine Düsenspitze 36 eingesetzt, die den in dem Materialrohr 32 ausgebildeten Strömungskanal 38 bis an eine (nicht dargestellte) Ebene einer (ebenfalls nicht sichtbaren) Formkavität fortsetzt. Die Düsenspitze 36 kann bei gleicher Funktionsweise auch einteilig mit dem Materialrohr 32 ausgebildet sein.

Auf dem Umfang der Wandung 40 des aus Stahl gefertigten Materialrohrs 32 ist eine keramische Dielektrikumschicht 42 aufgebracht auf der wiederum Heizleiterbahnen 44 angeordnet sind, die sich bahnförmig, mäanderförmig oder in sonstiger Art und Weise entlang des Außenumfangs der Dielektrikumschicht 42 erstrecken. Ferner ist über den Heizleiterbahnen 44 eine äußere Abdeckschicht 46 vorgesehen, welche die Heizleiterbahnen 44 und die darunter liegende Dielektrikumschicht 42 nach außen hin abdeckt und elektrisch isoliert. Die beliebig gestaltbaren Heizleiterbahnen 44 können je nach erforderlicher Leistung in unterschiedlicher Dichte und Anordnung auf der Dielektrikumschicht 42 aufgebracht sein. Hierdurch lässt sich bei Bedarf eine definierte Temperaturverteilung innerhalb des Materialrohrs 32 erzielen. Um die Heizleiterbahnen 44 mit elektrischer Energie zu versorgen, sind diese Anschlussleitungen 48 mit einer nicht näher dargestellten Energiequelle elektrisch verbunden.

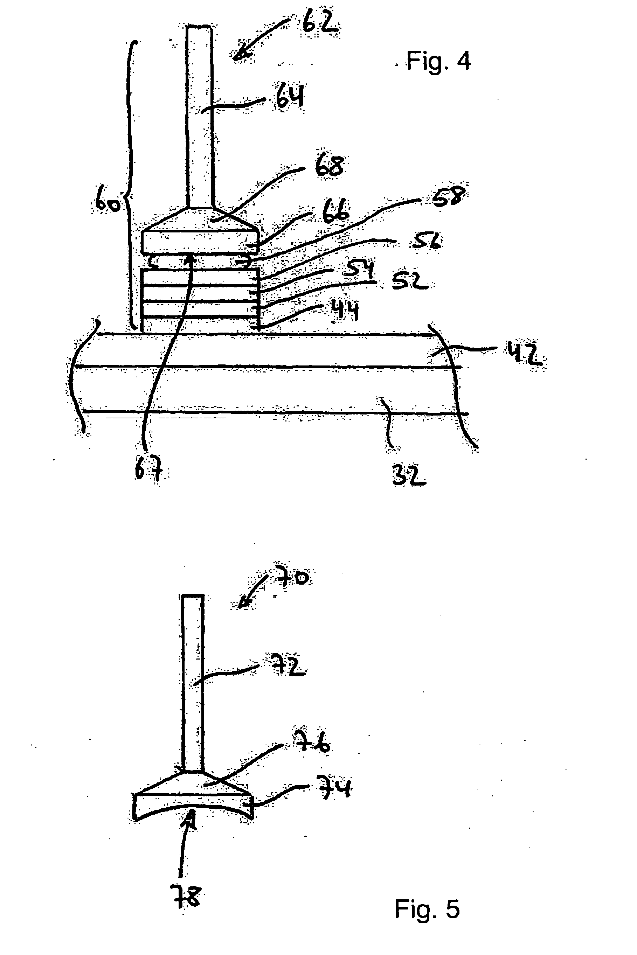

Die Fig. 3 und 4 zeigen zwei Ausführungsformen solcher erfindungsgemäßer elektrischer Verbindungen 50, 60 zwischen einer Heizleiterbahn 44 und einer Anschlussleitung 48 bzw. einem Anschlussstift 62.

Fig. 3 ist eine schematische Querschnittansicht einer ersten Ausführungsform einer elektrischen Verbindung 50 gemäß einer ersten Ausführungsform der vorliegenden Erfindung.

In Fig. 3 erkennt man das Materialrohr 32, die auf dem Materialrohr 32 ausgebildete Dielektrikumschicht 42 und die auf der Dielektrikumschicht 42 angeordnete Heizleiterbahn 44, die als ein erstes elektrisch leitendes Bauteil dient. Sie ist elektrisch mit der Anschlussleitung 48 verbunden, die ein zweites elektrisch leitendes Bauteil bildet. Die Anschlussleitung 48 ist an ihrem Ende umgebogen, um eine Kontaktfläche 49 zu erzeugen, wodurch das freie Ende im Wesentlichen eine L-förmige Form annimmt.

Die Heizleiterbahn 44 ist aus einem ersten elektrisch leitenden Material hergestellt, beispielsweise aus Ag, Pd und - je nach Ausführungsform - mit wenigstens einer Glasphase. Die Anschlussleitung 48 ist aus einem zweiten elektrisch leitenden Material hergestellt, vorliegend aus Silber oder einer Silberlegierung. Zwischen der Heizleiterbahn 44 und der Anschlussleitung 48 sind der Reihe nach eine erste elektrisch leitende Haftschicht 52, die vorliegend aus AgPd in einem Verhältnis von 3:1 hergestellt ist, eine zweite elektrisch leitende Haftschicht 54, die vorliegend aus AgPd in einem Verhältnis von 9:1 hergestellt ist, eine dritte elektrisch leitende Haftschicht 56, die vorliegend aus AgPd in einem Verhältnis von 27:1 hergestellt ist, und eine Kontaktpaste 58 vorgesehen, die vorliegend aus Silber hergestellt ist. Die einzelnen Schichten können bei Bedarf auch verschiedene Glasphasenanteile enthalten.

Bei den elektrisch leitenden Haftschichten 52, 54, 56 handelt es sich um Lötmaterialien oder Dickschichtpasten, die z.B. im Siebdruck aufgetragen werden. Die Heizleiterbahn 44, die erste elektrische leitende Haftschicht 52, die zweite elektrisch leitende Haftschicht 54, die dritte elektrisch leitende Haftschicht 56, die Kompaktpaste 58 und die Anschlussleitung 48 bilden gemeinsam die elektrische Verbindung 50.

Durch die Wahl der Materialien der elektrisch leitenden Haftschicht 52, 54, 56, deren Silbergehalt in Richtung der Heizleiterbahn 44 abnimmt, wird ein schrittweiser Übergang von dem Material der Anschlussleitung 48 zu dem Material der Heizleiterbahn 44 erzielt, wodurch die z.B. Haftfähigkeit zwischen den einzelnen Komponenten der elektrischen Verbindung 50 und somit die Abscherfestigkeit der gesamten elektrischen Verbindung 50 verbessert wird. Zudem wird die Temperaturstabilität der elektrischen Verbindung 50 positiv beeinflusst, was insbesondere bei dem vorliegenden Anwendungsgebiet von großem Vorteil ist.

Es sollte klar sein, dass die Anzahl der elektrisch leitenden Haftschichten nicht auf drei Schichten beschränkt ist. Erfindungswesentlich ist lediglich, dass mehr als zwei Haftschichten vorgesehen sind. Die optimale Anzahl von Haftschichten kann in Abhängigkeit vom Anwendungsfall beispielsweise experimentell ermittelt werden. Ferner ist die Kontaktpaste 58 optional vorgesehen und kann entsprechend weggelassen werden.

Zudem sollte klar sein, dass auf die Dielektrikumschicht 42 verzichtet werden kann, wenn das Materialrohr 32, das vorliegend als Substrat dient, aus einem elektrisch nicht leitenden Material hergestellt ist, wie beispielsweise aus Keramik oder dergleichen.

Fig. 4 zeigt eine schematische Querschnittansicht einer elektrischen Verbindung 60 gemäß einer zweiten Ausführungsform der vorliegenden Erfindung. Der in Fig. 4 dargestellte Aufbau der elektrischen Verbindung 60 unterscheidet sich lediglich dahingehend von der in Fig. 3 dargestellten elektrischen Verbindung 50, dass anstelle der Anschlussleitung 48 ein Anschlussstift 62 als zweites elektrisch leitendes Bauteil vorgesehen ist.

Der Anschlussstift 62 ist vorliegend aus Silber gefertigt. Er umfasst einen stiftförmigen Abschnitt 64 und einen Verbindungsabschnitt 66, der über die Kontaktpaste 58 mit der dritten elektrisch leitenden Haftschicht 56 in Kontakt kommt. Der Verbindungsabschnitt 66 ist scheibenförmig ausgebildet und weist einen größeren Durchmesser als der stiftförmige Abschnitt auf, um die Kontaktfläche 67 zu vergrößern. Zwischen dem stiftartigen Abschnitt 64 und dem Verbindungsabschnitt 66 ist ein Übergangsabschnitt 68 vorgesehen, der vorliegend kegelstumpfförmig ausgebildet ist, so dass der Durchmesser des stiftförmigen Abschnittes 64 und derjenige des Verbindungsabschnittes 66 kontinuierlich ineinander übergehen. Durch den Übergangsabschnitt 68 wird die Festigkeit des Anschlussstiftes 62 und somit dessen Lebensdauer erhöht. Es sollte klar sein, dass der Übergangsabschnitt 68 auch eine andere Form aufweisen kann, beispielsweise eine solche, bei welcher der Durchmesser des stiftförmigen Abschnittes 64 und derjenige des Verbindungsabschnittes 66 stufenartig ineinander übergehen.

Der Anschlussstift 62 mit dem zuvor beschriebenen Aufbau weist gegenüber der L-förmig gebogenen Anschlussleitung 48 gemäß Fig. 3 den Vorteil auf, dass die Zugbelastungen, die auf den Anschlussstift 62 wirken, noch besser gleichmäßig in allen Richtungen verteilt werden.

Fig. 5 ist eine schematische Ansicht, die einen alternativen Anschlussstift 70 zeigt, der für die in Fig. 4 dargestellte elektrische Verbindung 60 eingesetzt werden kann. Ähnlich wie der Anschlussstift 62 umfasst der Anschlussstift 70 einen stiftförmigen Abschnitt 72, einen im Wesentlichen tellerförmigen Verbindungsabschnitt 74 und einen Übergangsabschnitt 76, der den stiftförmigen Abschnitt 72 mit dem Verbindungsabschnitt 74 verbindet. Im Gegensatz zu dem Anschlussstift 62 ist eine Kontaktfläche 78 des Verbindungsabschnittes 74, die beim Erzeugen der elektrischen Verbindung über die Kontaktpaste 58 mit der dritten elektrisch leitenden Haftschicht 56 in Kontakt kommt, jedoch derart ausgebildet, dass ihre Kontur an diejenige der Heizleiterbahn 44 angepasst ist. Da das Materialrohr 32 und die auf diesem angeordnete Dielektrikumschicht 42, die in Fig. 1 dargestellt sind, zylindrisch ausgebildet sind, weist auch die Heizleiterbahn 44 eine entsprechende Wölbung auf, an welche die Kontaktfläche 78 des Verbindungsabschnittes 74 des Anschlussstiftes 70 nunmehr angepasst ist. Auf diese Weise kann eine noch bessere Verbindung erzielt werden.

Die Erfindung ist nicht auf eine der vorbeschriebenen Ausführungsformen beschränkt, sondern in vielfältiger Weise abwandelbar. So sollte beispielsweise klar sein, dass die Konturierung der Kontaktfläche 78 des Anschlussstiftes 70 in Abhängigkeit von der Kontur des ersten elektrisch leitenden Bauteils, vorliegend also in Abhängigkeit von der Kontur des Materialrohrs 32, auch anders gewählt werden kann. Die Anschlussleitung 48 und der Anschlussstift können endseitig mit einer weiterführenden elektrischen Leitung, beispielsweise mit einem Kabel verbunden sein, welches an das Temperatur-Regelgerät angeschlossen wird.

Man erkennt jedoch, dass die Erfindung eine elektrische Verbindung zwischen einem ersten elektrisch leitenden Bauteil aus einem ersten Material und einem zweiten elektrisch leitenden Bauteil aus einem zweiten Material betrifft, wobei das erste Material und das zweite Material unterschiedlich sind, wobei das erste elektrisch leitende Bauteil eine Heizeinrichtung einer Spritzgießdüse ist, wobei zwischen den elektrisch leitenden Bauteilen zumindest zwei die Verbindung erzeugende und elektrisch leitende Haftschichten aus unterschiedlichen Haftschichtmaterialien vorgesehen sind, wobei sich die Haftschichtmaterialien von dem ersten und zweiten Material unterscheiden, sodass die Haftschichtmaterialien eine stufenweise Anpassung der Hafteigenschaften vornehmen, damit die leitenden Bauteile dauerhaft fest miteinander verbunden sind.

### Bezugszeichenliste

- 10: elektrische Verbindung
- 12: Substrat
- 14: Dielektrikumschicht
- 16: Heizleiterbahn
- 18: Anschlussleitung
- 20: Kontaktpaste
- 30: Spritzgießdüse
- 32: Materialrohr
- 34: Sockel
- 36: Düsenspitze
- 38: Strömungskanal
- 40: Wandung
- 42: Dielektrikumschicht
- 44: Heizleiterbahn
- 46: Abdeckschicht
- 48: Anschlussleitung
- 50: elektrische Verbindung
- 52: erste Haftschicht
- 54: zweite Haftschicht
- 56: dritte Haftschicht
- 58: Kontaktpaste
- 60: elektrische Verbindung
- 62: Anschlussstift
- 64: stiftförmiger Abschnitt
- 66: Verbindungsabschnitt
- 68: Übergangsabschnitt
- 70: Anschlussstift
- 72: stiftförmiger Abschnitt
- 74: Verbindungsabschnitt
- 76: Übergangsabschnitt
- 78: Kontaktfläche

## Patentansprüche

1. Elektrische Verbindung (50; 60) zwischen einem ersten elektrisch leitenden Bauteil (44) aus einem ersten Material und einem zweiten elektrisch leitenden Bauteil (48; 62; 70) aus einem zweiten Material, wobei das erste Material und das zweite Material unterschiedlich sind, und wobei das erste elektrisch leitende Bauteil (44) eine Heizeinrichtung einer Spritzgießdüse ist, **dadurch gekennzeichnet, dass** zwischen den elektrisch leitenden Bauteilen (44, 48; 62; 70) wenigstens zwei die Verbindung erzeugende, elektrisch leitende Haftschichten (52, 54, 56) angeordnet sind, wobei die Haftschichten (52, 54, 56) unterschiedliche Eigenschaften, unterschiedliche Zusammensetzungen und/oder unterschiedliche Haftschichtmaterialien aufweisen, und wobei sich die Haftschichtmaterialien von dem ersten und zweiten Material unterscheiden.

2. Verbindung nach Anspruch 1, **dadurch gekennzeichnet, dass** jede Haftschicht (52, 54, 56) an eine jeweils direkt benachbart angeordnete Haftschicht (52, 54, 56) und/oder an ein direkt benachbart angeordnetes elektrisch leitendes Bauteil (44, 48; 62; 70) angepasst ist.

3. Verbindung nach Anspruch 1 oder 2, **dadurch gekennzeichnet, dass** jede Haftschicht (52, 54, 56) derart gewählt oder ausgebildet ist, dass deren Eigenschaften, Zusammensetzung und/oder Haftschichtmaterial an die Eigenschaften, die Zusammensetzung und/oder das Haftschichtmaterial einer jeweils direkt benachbart angeordneten Haftschicht (52, 54, 56) und/oder an die Eigenschaften, die Zusammensetzung und/oder das Material eines direkt benachbart angeordneten elektrisch leitenden Bauteils (44, 48; 62; 70) angepasst ist.

4. Verbindung nach einem der Ansprüche 1 bis 3, **dadurch gekennzeichnet, dass** die Eigenschaften, die Zusammensetzung und/oder das Haftschichtmaterial einer jeden Haftschicht (52, 54, 56) derart gewählt ist, dass deren Haftfähigkeit an die Haftfähigkeit einer jeweils direkt benachbart angeordneten Haftschicht (52, 54, 56) und/oder an die Haftfähigkeit eines direkt benachbart angeordneten elektrisch leitenden Bauteils (44, 48; 62; 70) angepasst ist.

5. Verbindung nach einem der Ansprüche 1 bis 4, **dadurch gekennzeichnet, dass** jede Haftschicht (52, 54, 56) eine andere Haftfähigkeit aufweist.

6. Verbindung nach einem der Ansprüche 1 bis 5, **dadurch gekennzeichnet, dass** die Haftschichten (52; 54; 56) bezüglich ihrer Eigenschaften, ihrer Zusammensetzungen, ihrer Haftschichtmaterialien, ihrer Haftfähigkeiten und/oder ihrer Wärmeausdehnungseigenschaften einen Gradientenaufbau bilden.

7. Verbindung nach einem der Ansprüche 1 bis 6, **dadurch gekennzeichnet, dass** das Haftschichtmaterial jeder Haftschicht (52, 54, 56) ein Lötmaterial, eine Kontaktpaste oder eine Dickschichtpaste ist.

8. Verbindung nach einem der Ansprüche 1 bis 7, **dadurch gekennzeichnet, dass** das Haftschichtmaterial jeder Haftschicht (52, 54, 56) Silber, Palladium und/oder wenigstens einen Glasphasenanteil umfasst.

9. Verbindung nach einem der Ansprüche 1 bis 8, **dadurch gekennzeichnet, dass** die Heizeinrichtung eine Dickschichtheizung ist.

10. Verbindung nach einem der Ansprüche 1 bis 9, **dadurch gekennzeichnet, dass** das zweite elektrisch leitende Bauteil (48) ein Draht oder eine Litze ist.

11. Verbindung (60) nach einem der Ansprüche 1 bis 10, **dadurch gekennzeichnet, dass** das zweite elektrisch leitende Bauteil (62; 70) ein elektrisch leitender Anschlussstift ist.

12. Verbindung nach Anspruch 11, **dadurch gekennzeichnet, dass** der Anschlussstift (62; 70) einen stiftförmigen Abschnitt (64; 72) und einen Verbindungsabschnitt (66; 74) aufweist.

13. Verbindung nach Anspruch 12, **dadurch gekennzeichnet, dass** der Verbindungsabschnitt (66; 74) scheibenförmig ausgebildet ist und einen größeren Durchmesser als der stiftförmige Abschnitt (64; 72) aufweist.

14. Verbindung nach Anspruch 11 oder 12, **dadurch gekennzeichnet, dass** die der Haftschicht (52, 54, 56) zugewandte Seite des Verbindungsabschnitts (74) eine Kontur aufweist, die an die Kontur des anderen elektrisch leitenden Bauteils (44) angepasst ist.

15. Verbindung nach einem der Ansprüche 11 bis 14, **dadurch gekennzeichnet, dass** zwischen dem stiftförmigen Abschnitt (64; 72) und dem Verbindungsabschnitt (66; 74) zumindest ein Übergangsabschnitt (68; 76) vorgesehen ist, der derart ausgebildet ist, dass der Durchmesser des stiftförmigen Abschnitts (64; 72) und derjenige des Verbindungsabschnitts (66; 74) stufenartig oder kontinuierlich ineinander übergehen.

## Claims

1. An electrical connection (50; 60) between a first electrically conductive component (44) made of a first material and a second electrically conductive component (48; 62; 70) made of a second material, wherein the first material and the second material are different and wherein the first electrically conductive component (44) is a heating device for an injection molding nozzle, **characterized in that** between the electrically conductive components (44, 48; 62; 70) at least two electrically conductive adhesive layers (52, 54, 56) generating the connection are arranged, wherein the adhesive layers (52, 54, 56) have different properties, different compositions and/or different adhesive layer materials, and wherein the adhesive layer materials differ from the first and second materials.

2. The connection according to claim 1, **characterized in that** each adhesive layer (52, 54, 56) is adapted to an adhesive layer (52, 54, 56) arranged in each case directly adjacent and/or adapted to an electrically conductive component (44, 48; 62; 70) arranged directly adjacent.

3. The connection according to claim 1 or claim 2, **characterized in that** each adhesive layer (52, 54, 56) is selected or configured such that the adhesive layer's properties, composition and/or adhesive layer material are adapted to the properties, the composition and/or the adhesive layer material of an adhesive layer (52, 54, 56) arranged in each case directly adjacent and/or adapted to the properties, the composition and/or the material of an electrically conductive component (44, 48; 62; 70) arranged directly adjacent.

4. The connection according to any one of the claims 1 to 3, **characterized in that** the properties, the composition and/or the adhesive layer material of each adhesive layer (52, 54, 56) are selected such that the adhesive layer's adhesion is adapted to the adhesion of an adhesive layer (52, 54, 56) arranged in each case directly adjacent and/or adapted to the adhesion of an electrically conductive component (44, 48; 62; 70) arranged directly adjacent.

5. The connection according to any one of the claims 1 to 4, **characterized in that** each adhesive layer (52, 54, 56) has a different adhesion.

6. The connection according to any of the claims 1 to 5, **characterized in that** with regard to their properties, their compositions, their adhesive layer materials, their adhesions and/or their thermal expansion properties, the adhesive layers (52; 54; 56) form a gradient structure.

7. The connection according to any one of the claims 1 to 6, **characterized in that** the adhesive layer material of each adhesive layer (52, 54, 56) is a soldering material, a contact paste or a thick film paste.

8. The connection according to any one of the claims 1 to 7, **characterized in that** the adhesive layer material of each adhesive layer (52, 54, 56) comprises silver, palladium and/or at least a proportion of glass phase material.

9. The connection according to any one of the claims 1 to 8, **characterized in that** the heating device is a thick film heater.

10. The connection according to any one of the claims 1 to 9, **characterized in that** the second electrically conductive component (48) is a wire or a stranded wire.

11. The connection (60) according to any one of the claims 1 to 10, **characterized in that** the second electrically conductive component (62; 70) is an electrically conductive pin.

12. The connection according to claim 11, **characterized in that** the pin (62; 70) has a pin-shaped portion (64; 72) and a connecting portion (66; 74).

13. The connection according to claim 12, **characterized in that** the connecting portion (66; 74) is disk-shaped and has a larger diameter than the pin-shaped portion (64; 72).

14. The connection according to claim 11 or claim 12, **characterized in that** the connecting portion's (74) side facing toward the adhesive layer (52, 54, 56) has a contour that is adapted to the contour of the other electrically conductive component (44).

15. The connection according to any one of the claims 11 to 14, **characterized in that** between the pin-shaped portion (64; 72) and the connecting portion (66; 74) at least one transition portion (68; 76) is provided which is formed in such a manner that the diameter of the pin-shaped portion (64; 72) and the diameter of the connecting portion (66; 74) transition into one another in a step-like or continuous manner.

## Revendications

1. Connexion électrique (50 ; 60) entre un premier composant conducteur de l'électricité (44), fait d'un premier matériau, et un second composant conducteur de l'électricité (48 ; 62 ; 70), fait d'un second matériau, le premier matériau et le second matériau étant différents, et le premier composant conducteur de l'électricité (44) étant un dispositif de chauffage pour une buse de moulage par injection, **caractérisée par le fait qu'**entre les composants conducteurs de l'électricité (44, 48 ; 62 ; 70), sont disposées au moins deux couches adhésives conductrices de l'électricité (52, 54, 56), générant la connexion, les couches adhésives (52, 54, 56) ayant des propriétés différentes, des compositions différentes et/ou des matières de couche adhésive différentes, et les matières de couche adhésive diffèrent des premier et second matériaux.

2. Connexion selon la revendication 1, **caractérisée par le fait que** chaque couche adhésive (52, 54, 56) est adaptée à une couche adhésive (52, 54, 56) disposée dans chaque cas directement adjacente de et/ou adaptée à un composant conducteur de l'électricité (44, 48 ; 62 ; 70) disposé directement adjacent.

3. Connexion selon la revendication 1 ou la revendication 2, **caractérisée par le fait que** chaque couche adhésive (52, 54, 56) est choisie ou configurée de telle sorte que les propriétés, la composition et/ou la matière de couche adhésive, de la couche adhésive, sont adaptées aux propriétés, à la composition et/ou à la matière de couche adhésive d'une couche adhésive (52, 54, 56) disposée dans chaque cas directement adjacente et/ou adaptées aux propriétés, à la composition et/ou à la matière d'un composant conducteur de l'électricité (44, 48 ; 62 ; 70) disposé directement adjacent.

4. Connexion selon l'une quelconque des revendications 1 à 3, **caractérisée par le fait que** les propriétés, la composition et/ou la matière de couche adhésive de chaque couche adhésive (52, 54, 56) sont choisies de telle sorte que l'adhérence de la couche adhésive est adaptée à l'adhérence d'une couche adhésive (52, 54, 56) disposée dans chaque cas directement adjacente et/ou adaptée à l'adhérence d'un composant conducteur de l'électricité (44, 48 ; 62 ; 70) disposé directement adjacent.

5. Connexion selon l'une quelconque des revendications 1 à 4, **caractérisée par le fait que** chaque couche adhésive (52, 54, 56) a une adhérence différente.

6. Connexion selon l'une quelconque des revendications 1 à 5, **caractérisée par le fait que**, en ce qui concerne leurs propriétés, leurs compositions, leurs matières de couche adhésive, leurs adhérences et/ou leurs propriétés de dilatation thermique, les couches adhésives (52 ; 54 ; 56) forment une structure à gradient.

7. Connexion selon l'une quelconque des revendications 1 à 6, **caractérisée par le fait que** la matière de couche adhésive de chaque couche adhésive (52, 54, 56) est une matière de brasage, une pâte de contact ou une pâte de film épais.

8. Connexion selon l'une quelconque des revendications 1 à 7, **caractérisée par le fait que** la matière de couche adhésive de chaque couche adhésive (52, 54, 56) comprend de l'argent, du palladium et/ou au moins une proportion de matière à phase vitreuse.

9. Connexion selon l'une quelconque des revendications 1 à 8, **caractérisée par le fait que** le dispositif de chauffage est un élément chauffant à film épais.

10. Connexion selon l'une quelconque des revendications 1 à 9, **caractérisée par le fait que** le second composant conducteur de l'électricité (48) est un fil ou un fil toronné.

11. Connexion (60) selon l'une quelconque des revendications 1 à 10, **caractérisée par le fait que** le second composant conducteur de l'électricité (62 ; 70) est une broche conductrice de l'électricité.

12. Connexion selon la revendication 11, **caractérisée par le fait que** la broche (62 ; 70) a une partie en forme de broche (64 ; 72) et une partie de connexion (66 ; 74).

13. Connexion selon la revendication 12, **caractérisée par le fait que** la partie de connexion (66 ; 74) est en forme de disque et a un plus grand diamètre que la partie en forme de broche (64 ; 72).

14. Connexion selon la revendication 11 ou la revendication 12, **caractérisée par le fait que** le côté de la partie de connexion (74) tourné vers la couche adhésive (52, 54, 56) a un contour qui est adapté au contour de l'autre composant conducteur de l'électricité (44).

15. Connexion selon l'une quelconque des revendications 11 à 14, **caractérisée par le fait qu'**entre la partie en forme de broche (64 ; 72) et la partie de connexion (66 ; 74), est prévue au moins une partie de transition (68 ; 76), laquelle est formée d'une manière telle que le diamètre de la partie en forme de broche (64 ; 72) et le diamètre de la partie de connexion (66 ; 74) change de l'un à l'autre d'une manière en escalier ou continue.
